**Europäisches Patentamt**

**European Patent Office**

**Office européen des brevets**

(19)

(11) Numéro de publication : **0 405 355 B1**

# (12) FASCICULE DE BREVET EUROPEEN

(45) Date de publication du fascicule du brevet :
**09.11.94 Bulletin 94/45**

(51) Int. Cl.$^5$ : **H04L 1/00, H03K 5/19**

(21) Numéro de dépôt : **90111866.1**

(22) Date de dépôt : **22.06.90**

(54) **Dispositif de détection d'une signalisation formée d'une série continue d'éléments binaires de même valeur.**

(30) Priorité : **28.06.89 FR 8908623**

(43) Date de publication de la demande :
**02.01.91 Bulletin 91/01**

(45) Mention de la délivrance du brevet :
**09.11.94 Bulletin 94/45**

(84) Etats contractants désignés :
**AT BE CH DE ES FR GB IT LI NL SE**

(56) Documents cités :
**EP-A- 0 020 070**
**EP-A- 0 306 585**
**DE-A- 3 246 211**
**FR-A- 2 557 404**

(73) Titulaire : **ALCATEL CIT**
**12 Rue de la Baume**
**F-75008 Paris (FR)**

(72) Inventeur : **Regent, Philippe**
**8, rue Nicéphore Niepce**
**F-91410 Dourdan (FR)**

(74) Mandataire : **Weinmiller, Jürgen et al**
**Lennéstrasse 9**
**Postfach 24**
**D-82336 Feldafing (DE)**

EP 0 405 355 B1

## Description

La présente invention concerne un dispositif de détection dans un signal binaire d'une signalisation formée nominalement d'une série continue d'éléments binaires de même valeur.

L'invention s'applique notamment à la détection de signal d'indication d'alarme pour équipement de multiplexage numérique.

Un équipement de multiplexage numérique doit remplir, outre ses fonctions principales de multiplexage, et inversement de démultiplexage, numérique, une fonction auxiliaire de surveillance du bon fonctionnement global de cet équipement.

Dans le cadre de cette surveillance est notamment effectuée en entrée d'un démultiplexeur, une détection de signal d'indication d'alarme en provenance d'un multiplexeur éloigné associé à ce démultiplexeur.

Conformément à la recommandation G.751 du CCITT qui définit les caractéristiques des équipements de multiplexage numériques fonctionnant aux débits binaires de 34 368 k bit/s et 139 264 k bit/s, le contenu binaire d'un signal d'indication d'alarme (appelé aussi par la suite SIA) consiste en une série continue de "1" binaires. Un certain nombre de "o" peuvent cependant apparaître dus à d'éventuelles erreurs de transmission. Cette recommandation stipule que le principe utilisé pour la détection de signal d'indication d'alarme doit rendre cette détection possible même en présence d'un taux d'erreur égal à $10^{-3}$.

Bien que cela ne soit pas précisé par cette recommandation, on conçoit cependant qu'au delà d'un certain taux d'erreur la détection de SIA ne doit plus être rendue possible.

Pour détecter, dans un signal binaire reçu, une signalisation formée d'une série d'éléments binaires, de même valeur ou non, on procède habituellement (voir par exemple les documents EP-A- 0 306 585, DE-A- 3 246 211, EP-A- 0 020 070, FR-A-2 557 404) par comparaison d'une série d'éléments binaires reçus avec la série d'éléments binaires formant ladite signalisation.

La présente invention a pour but de permettre la réalisation d'un dispositif de détection particulièrement simple qui dans le cadre d'une application à la détection d'un SIA permet notamment de répondre à la recommandation du CCITT.

L'invention est basée sur un comptage des éléments binaires du signal entrant sur une certaine durée de signal ayant la valeur "O" dans le cadre d'une application à la détection d'un signal d'indication d'alarme, suivi d'une comparaison du résultat de ce comptage à une valeur seuil.
La valeur de ce seuil est choisie de préférence de façon à maximiser sensiblement en cas de présence effective d'un SIA, à la fois la probabilité d'avoir un nombre d'éléments binaires à "o" inférieur à ce seuil pour un taux d'erreur égal à $10^{-3}$, et la probabilité d'avoir un nombre d'éléments binaires à "o" supérieur à ce seuil pour un taux d'erreur supérieur à $3.10^{-3}$.

La durée de comptage est quant à elle choisie suffisamment longue pour qu'un nombre d'éléments binaires à "o" inférieur à ce seuil sur cette durée s'applique le plus vraisemblablement à un signal d'indication d'alarme et non à un signal utile.

Le but visé ci-dessus est atteint par le dispositif tel que défini par la revendication 1. En ce qui concerne des détails d'un exemple de mise en oeuvre préféré de ce dispositif, référence est faite aux revendications secondaires.

Les caractéristiques de la présente invention apparaîtront plus clairement à la lecture de la description suivante d'un exemple de réalisation, faite en relation avec les dessins ci-annexés dans lesquels :

- la figure 1 représente un schéma d'un dispositif de détection de signal d'indication d'alarme suivant l'invention,
- les figures 2 et 3 représentent des courbes illustrant sur un exemple le choix des différents paramètres évoqués ci-dessus seuil, taux d'erreur, durée de comptage.

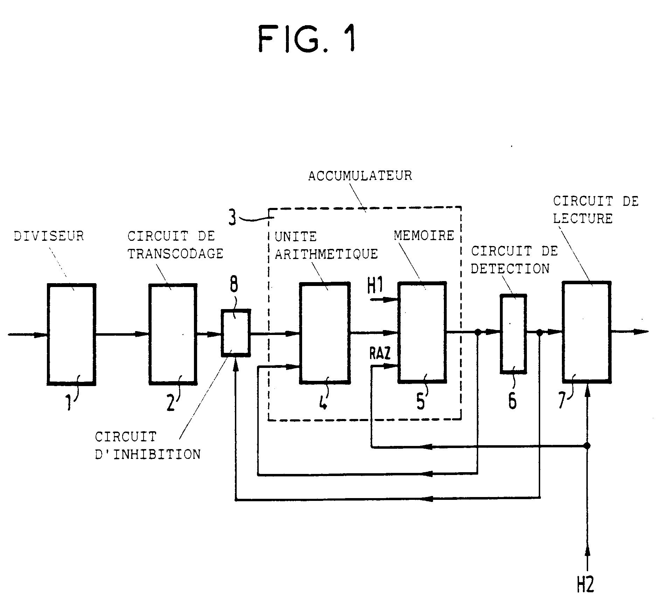

Le dispositif de détection de signal d'indication d'alarme représenté sur la figure 1 comporte un diviseur 1 permettant de diviser le train numérique entrant à haut débit, soit N bit/s, correspondant au signal numérique multiplexé, en n trains numériques parallèles de débit réduit, soit $\frac{N}{n}$ bit/s.

Ce diviseur ne participe pas à la détection de signal d'indication d'alarme proprement dite mais permet de faciliter la réalisation pratique de celle-ci, du fait du débit moindre en aval de ce diviseur.

A titre d'exemple, on considérera les valeurs N = $140.10^6$ bit/s et n = 4, et on prendra une durée de comptage égale à 14640 éléments binaires (soit cinq trames) et un seuil d'éléments binaires à "o" fixé à 24 éléments binaires.

En sortie du diviseur 1 est disposé un circuit de transcodage 2 effectuant, à un rythme de 140/4 MHz, une conversion de chaque mot de quatre éléments binaires disponible en sortie de ce diviseur, en un nombre binaire naturel codé sur trois éléments binaires, correspondant au nombre d'éléments binaires égaux à "o" dans le mot de quatre bits reçu.

En sortie du circuit de transcodage est disposé un accumulateur 3 formé d'une unité arithmétique 4 associée à une mémoire 5. L'unité arithmétique 4 additionne le nombre obtenu à un instant donné en sortie du circuit de transcodage 2 au nombre obtenu précédemment en sortie de cette unité 4 et mémorisé dans la mémoire 5, la mémoire 5, formée par exemple d'un registre à bascules en parallèle, étant régulièrement commandée par un signal d'horloge $H_1$ au rythme de 140/4 MHz pour enregistrer à ce rythme les valeurs successives en sortie de l'unité arithmétique 4.

La détection du passage du contenu de l'accumulateur c'est-à-dire de la mémoire 5 par la valeur seuil, c'est-à-dire dans l'exemple considéré par la valeur décimale 24, est réalisée par un circuit de détection 6 qui délivre en sortie un signal logique indiquant par son niveau, par exemple 1 ou 0, que le contenu de l'accumulateur est inférieur ou non à la valeur seuil.

Le résultat de cette détection est enregistré dans une mémoire 7 formée par exemple d'une simple bascule, en fin de fenêtre de comptage, une fenêtre de comptage comportant dans l'exemple considéré 14640 éléments binaires. Cet enregistrement s'effectue sous la commande d'un signal d'horloge $H_2$ de fréquence 140/14640 MHz, qui assure par ailleurs une remise à zéro à ce rythme de la mémoire 5 de l'accumulateur.

Un circuit d'inhibition 8 est par ailleurs inséré entre la sortie du circuit de transcodage 2 et l'entrée de l'unité arthmétique 4 qui reçoit les signaux délivrés par ce circuit de transcodage, afin de forcer à zéro cette entrée de l'unité arithmérique une fois détecté le franchissement du seuil par le circuit de détection 6.

On obtient ainsi en sortie de la mémoire 7, en fin de fenêtre de comptage, un signal logique indiquant par son niveau, ici 1 ou 0, la détection d'un SIA ou la détection d'absence de SIA.

La réalisation pratique du schéma de la figure 1 se fait au moyen de circuits ou composants bien connus de l'homme du métier, n'appelant pas de description plus détaillée.

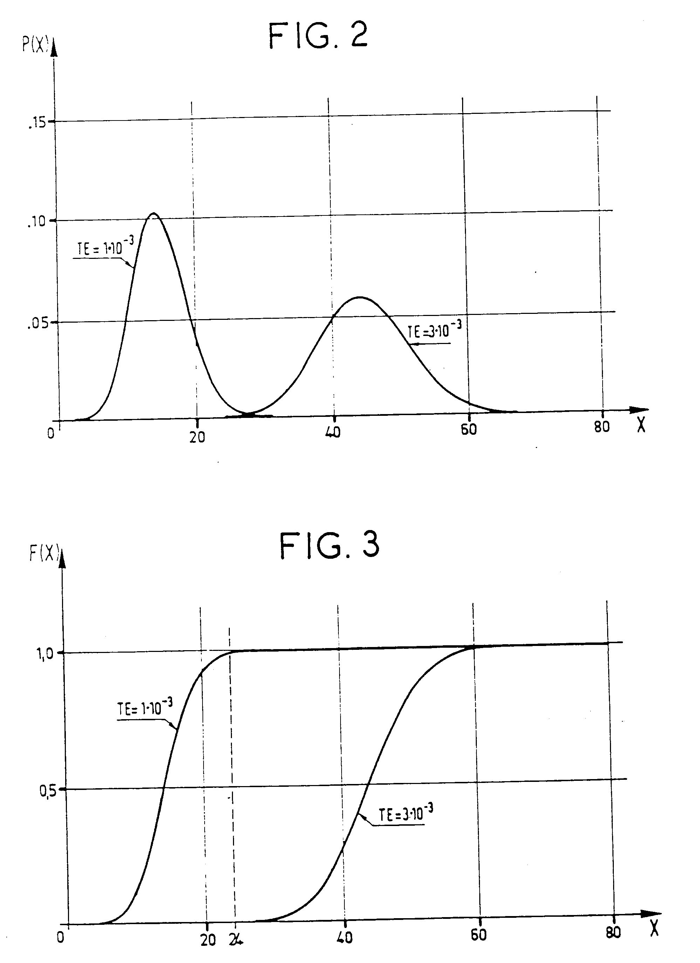

Le choix de la valeur 24 comme seuil sera mieux compris en regard des figures 2 et 3.

La figure 2 représente la probabilité d'avoir X bits faux parmi 14640 pour un taux d'erreur de $10^{-3}$ et pour un taux d'erreur de $3.10^{-3}$, pour X variant de 0 à 80, c'est-à-dire la probabilité, lorsque le train numérique entrant est effectivement constitue d'un SIA, d'avoir X bits à "O" parmi 14640 pour un taux d'erreur de $10^{-3}$ et pour un taux d'erreur de $3.10^{-3}$.

Cette probabilité s'exprime par la fonction

$$P(x) = C_{14640}^{X} (1 - TE)^{14640 - X} TE^{X}$$

où TE désigne le taux d'erreur,

La figure 3 représente la fonction de répartition F (X) pour chacun de ces deux taux d'erreur, c'est-à-dire la probabilité d'avoir un nombre de bits faux inférieur à x parmi 14640 pour chacun de ces deux taux d'erreur, c'est-à-dire encore la probabilité d'avoir un nombre de bits à "O" inférieur à X parmi 14640 pour chacun de ces deux taux d'erreur lorsque le train numérique entrant est effectivement constitué d'un SIA.

Il apparait ainsi que pour un seuil fixé à 24 bits faux :

- la probabilité d'avoir un nombre de bits faux inférieur à 24 en présence d'un taux d'erreur de $10^{-3}$ est de 0,984 d'où une très grande probabilité de reconnaissance de SIA dans ce cas,
- la probabilité d'avoir un nombre de bits faux supérieur à 24, en présence d'un taux d'erreur de $3.10^{-3}$, est de 0,999 d'où une très grande probabilité de reconnaissance d'absence de SIA dans ce cas.

Ainsi qu'il ressort des figures 2 et 3, la valeur exacte de X qui maximise la probabilité d'avoir un nombre de bits faux inférieur à X parmi 14640 pour chacun des deux taux d'erreurs précédents est légèrement supérieure à 24. Compte tenu de la variation très faible de ces probabilités pour des valeurs de X voisines de cette valeur exacte, le choix de la valeur 24 comme valeur de seuil a été fait en prenant en considération un critère de simplicité de réalisation du circuit de détection 6.

## Revendications

1. Dispositif de détection dans un signal binaire d'une signalisation formée nominalement d'une série d'éléments binaires de même valeur, caractérisé en ce qu'il comporte :
   - des moyens (2, 4, 5) de comptage des éléments binaires du signal incident ayant une valeur binaire opposée à la valeur binaire considérée sur une durée de comptage déterminée,
   - des moyens (6) de comparaison du résultat de ce comptage à une valeur seuil prédéterminée, ladite signalisation étant considérée comme ayant été reçue, ou non, en fonction de la situation de ce résultat de comptage par rapport à cette valeur seuil prédéterminée.

2. Dispositif selon la revendication 1, caractérisé en ce que la valeur seuil est choisie de façon à maximiser sensiblement lorsque ledit signal est constitué effectivement de ladite signalisation, à la fois la probabilité d'avoir un nombre d'éléments binaires ayant ladite valeur binaire opposée sur la durée de comptage, inférieur à cette valeur seuil, pour une première valeur de taux d'erreur affectant la transmission dudit signal, et la probabilité d'avoir un nombre d'éléments binaires ayant ladite valeur binaire opposée sur la durée de comptage, supérieur à cette valeur seuil, pour une deuxième valeur de taux d'erreur supérieure à la première.

3. Dispositif selon la revendication 2, caractérisé en ce qu'il est utilisé pour la détection de signal d'indication d'alarme pour équipement de multiplexage numérique à 140 Mbit/s, et en ce que la durée de comptage est alors fixée à 14640 éléments binaires, la valeur seuil à 24, la première valeur de taux d'erreur à $10^{-3}$, et la deuxième valeur de taux d'erreur à $3.10^{-3}$.

4. Dispositif selon l'une des revendications 1 à 3, caractérisé en ce que, le débit binaire du signal incident étant de N bit/s, il comporte :
 - un diviseur (1) délivrant "n" signaux binaires de débit $\frac{N}{n}$ bits/s,
 - un circuit de transcodage (2) convertissant chaque mot de n éléments binaires disponible en sortie du diviseur (1) en un nombre binaire naturel correspondant au nombre d'éléments binaires ayant ladite valeur binaire opposée dans le mot de n éléments binaires considéré,
 - un accumulateur (3) additionnant les nombres binaires obtenus successivement en sortie du circuit de transcodage, sur la durée de comptage considérée,
 - un circuit de détection (6) détectant le franchissement de la valeur seuil considérée par le signal de sortie de l'accumulateur.

## Patentansprüche

1. Vorrichtung zur Erfassung einer Signalisation in einem Binärsignal, die nominell aus einer Serie von Binärelementen des gleichen Werts gebildet ist, dadurch gekennzeichnet, daß sie aufweist:
 - Mittel (2, 4, 5) zum Zählen der Binärelemente des eintreffenden Signals über eine bestimmte Zähldauer mit einem Binärwert, der dem betrachteten Wert entgegengesetzt ist,
 - Mittel (6) zum Vergleichen des Ergebnisses dieser Zählung mit einem vorbestimmten Schwellenwert, wobei die Signalisation in Abhängigkeit von diesem Zählergebnis relativ zum vorbestimmten Schwellenwert als empfangen oder nicht empfangen betrachtet wird.

2. Vorrichtung nach Anspruch 1, dadurch gekennzeichnet, daß der Schwellenwert so gewählt ist, daß er im wesentlichen sowohl die Wahrscheinlichkeit maximiert, wenn das genannte Signal tatsächlich aus der genannten Signalisation besteht, für eine feste Fehlerquote, die die Übertragung des Signals beeinflußt, eine unter dem Schwellenwert liegende Anzahl von Binärelementen des erwähnten entgegengesetzten Binärwerts über die Zähldauer zu erfassen, als auch die Wahrscheinlichkeit maximiert, für eine zweite Fehlerquote, die größer als die erste ist, eine über diesem Schwellenwert liegende Anzahl von Binärelementen mit dem genannten entgegengesetzten Binärwert über die Zähldauer zu erfassen.

3. Vorrichtung nach Anspruch 2, dadurch gekennzeichnet, daß sie zur Erfassung des Alarmanzeigesignals für eine mit 140 Mbit/s arbeitende digitale Multiplexeinrichtung verwendet wird und daß die Zähldauer somit auf 14640 Binärelemente, der Schwellenwert auf 24, die erste Fehlerquote auf $10^{-3}$ und die zweite Fehlerquote auf $3 \times 10^{-3}$ festgesetzt ist.

4. Vorrichtung nach einem der Ansprüche 1 bis 3, dadurch gekennzeichnet, daß sie bei einem binären Durchsatz des eintreffenden Signals von N Bit/s aufweist:
 - einen Teiler (1), der "n" Binärsignale mit einem Durchsatz von je N/n Bit/s liefert,
 - eine Transkodierschaltung (2), die jedes am Ausgang des Teilers (1) verfügbare aus n Binärelementen bestehendes Wort in eine natürliche Binärzahl umwandelt, die der Anzahl der binären Elemente entspricht, welche in dem betrachteten Wort von n Binärelementen den genannten entgegengesetzten Binärwert haben,
 - einen Akkumulator (3), der die nacheinander am Ausgang der Transkodierschaltung erhaltenen Binärzahlen über die betrachtete Zähldauer addiert,
 - eine Erfassungsschaltung (6), die das Übersteigen des betrachteten Schwellenwerts durch das Ausgangssignal des Akkumulators erfaßt.

## Claims

1. Device for detecting in a binary signal signalling nominally in the form of a series of binary digits of the same value, characterised in that it comprises:
 - means (2, 4, 5) for counting binary digits of the incoming signal with a binary value opposite the binary value in question over a specific count time,
 - means (6) for comparing the result of said count to a predetermined threshold value, said signalling being deemed to have been received or not depending on the situation of said count result relative to said predetermined threshold value.

2. Device according to claim 1 characterised in that the threshold value is chosen substantially to maximise when said signal actually comprises said signalling both the probability of having a number of binary digits having said opposite binary value over the count time less than said threshold value for a first error rate value affecting the transmission of said signal and the probability of having a number of binary digits having said opposite binary value over the count time greater than said threshold value for a second error rate value greater than the first.

3. Device according to claim 2 characterised in that it is used for alarm indication signal detection in 140 Mbit/s digital multiplexing equipment and in that the count time is set at 14 640 binary digits, the threshold value at 24, the first error rate value at $10^{-3}$ and the second error rate value at $3.10^{-3}$.

4. Device according to any one of claims 1 to 4 characterised in that the bit rate of the incoming signal is n bit/s and it comprises:
   - a divider (1) supplying "$\underline{n}$" binary signals at a bit rate of N/n bit/s,
   - a transcoder circuit (2) converting each word of $\underline{n}$ binary digits available at the output of the divider (1) into a natural binary number corresponding to the number of binary digits having said opposite binary value in the word of binary digits in question,
   - an accumulator (3) adding the binary numbers successively obtained at the output of the transcoder circuit over the count time in question,
   - a detector circuit (6) detecting crossing of the threshold value in question by the accumulator output signal.

# FIG. 1

ACCUMULATEUR

DIVISEUR   CIRCUIT DE
TRANSCODAGE

3

UNITE
ARITHMETIQUE

MEMOIRE

CIRCUIT DE
LECTURE

CIRCUIT DE
DETECTION

8

H1

RAZ

1   2   4   5   6   7

CIRCUIT
D'INHIBITION

H2

# FIG. 2

# FIG. 3